(19) Europäisches Patentamt

European Patent Office

Office européen des brevets

(11) Veröffentlichungsnummer: **0 256 395 B1**

(12) **EUROPÄISCHE PATENTSCHRIFT**

(45) Veröffentlichungstag der Patentschrift: **01.07.92**

(21) Anmeldenummer: **87111093.8**

(22) Anmeldetag: **31.07.87**

(51) Int. Cl.⁵: **C23C 18/28**

(54) **Verfahren zur Verbesserung der Haftfestigkeit von stromlos abgeschiedenen Metallschichten auf Kunststoffoberflächen.**

(30) Priorität: **12.08.86 DE 3627256**

(43) Veröffentlichungstag der Anmeldung:
**24.02.88 Patentblatt 88/08**

(45) Bekanntmachung des Hinweises auf die
Patenterteilung:
**01.07.92 Patentblatt 92/27**

(84) Benannte Vertragsstaaten:
**AT BE CH DE ES FR GB IT LI NL**

(56) Entgegenhaltungen:
EP-A- 0 125 617
EP-A- 0 131 195
US-A- 3 546 009
US-A- 4 469 714

(73) Patentinhaber: **BAYER AG**

**W-5090 Leverkusen 1 Bayerwerk(DE)**

(72) Erfinder: **Giesecke, Henning, Dr.**
**Walter-Flex-Strasse 18**
**W-5090 Leverkusen 1(DE)**
Erfinder: **Wolf, Gerhard Dieter, Dr.**
**Wilhelm-Busch-Strasse 29**
**W-4047 Dormagen 5(DE)**
Erfinder: **Müller, Hanns Peter, Dr.**
**Weizenfeld 36**
**W-5060 Bergisch-Gladbach 2(DE)**
Erfinder: **von Gizycki, Ulrich, Dr.**
**Wiembachallee 24**
**W-5090 Leverkusen 3(DE)**
Erfinder: **Wienkenhöver, Martin, Dr.**
**Gustav-Freytag-Strasse 2**
**W-5090 Leverkusen 1(DE)**

EP 0 256 395 B1

**Beschreibung**

Es ist allgemein bekannt, daß man zum Zwecke der Erzielung haftfester Metallauflagen auf elektrisch nicht leitenden Trägerkörpern zunächst einen haftvermittelnden Lack auf der Basis von vorzugsweise ABS-Polymerisaten auf die Oberfläche aufträgt. Der Nachteil dieser Vorbehandlungsmethode besteht jedoch darin, daß der mit dieser Lackschicht überzogene Formkörper vor der eigentlichen Metallisierung zwecks Aufrauhung der Oberfläche mit einer Beize behandelt werden muß (vgl. z.B. DE-A 1 958 839).

Es ist deshalb bereits vorgeschlagen worden, nichtmetallische Substratoberflächen ohne vorheriges Beizen direkt mit Aktivatorlösungen für die stromlose Metallisierung zu behandeln, die als Haftvermittler komplizierte Gemische aus Acrylnitril/Butadien-Copolymerisaten und gegebenenfalls Phenolharzen enthalten (vgl. z.B. US 3 305 460 und 3 560 257).

Ein derartiges Verfahren konnte sich jedoch bisher in der Technik nicht durchsetzen, da die Haftfestigkeit der erzeugten Metallschichten nicht ausreichend ist und die haftvermittelnden Polymere, die insbesondere in der Leiterplattentechnik geforderten hohen Anforderungen an die thermischen und elektrischen Eigenschaften nicht erfüllen.

Das Verfahren gemäß US 4 368 281 liefert demgegenüber zwar bessere Haftfestigkeiten, jedoch werden dafür verhältnismäßig größe Aktivatormengen, nämlich 5-16 Gew.-%, benötigt.

Es wurde nun überraschenderweise gefunden, daß man ohne die genannten Nachteile gut haftende Metallschichten auf Kunststoffoberflächen aufbringen kann, wenn man auf diese ohne Beizen eine Druckpastenformulierung aufbringt, die als Bestandteile

a) 0.03-4.00 Gew.% einer organischen Edelmetallverbindung als Aktivator

b) 10-30 Gew.% eines Polyurethanelastomers als Bindemittel

c) 5 - 25 Gew.% eines Füllstoffs und

d) mindestens 40 Gew.% eines halogenfreien Lösungsmittels oder Lösungsmittelgemisches mit einem Flammpunkt >21°C und Siedepunkt >100°C, enthält, das Lösungsmittel entfernt, die getrocknete Oberfläche durch Reduktion aktiviert und stromlos metallisiert.

Es ist überraschend, daß die erfindungsgemäßen Formulierungen eine haftfeste Metallisierung bewirken, da auf Flächen, die nur mit den erfindungsgemäßen Bindemitteln beschichtet wurden, keine haftfeste Metallisierung erreicht wird. Erst die Verwendung der erfindungsgemäßen Formulierungen bewirkt eine haftfeste chemische Metallisierung.

Bevorzugte Druckpasten enthalten 0,05-3 % an Komponente a) und 60-80 % an Komponente d).

Die erfindungsgemäßen Bindemittel sind aus der Polyurethanchemie bekannt. Sie werden beispielsweise hergestellt durch Umsetzung von Estern und/oder Ethern mit Isocyanaten.

Zur Herstellung einer lagerstabilen Formulierung ist es vorteilhaft, Polyurethane einzusetzen, die keine freien Isocyanatgruppen mehr enthalten.

Als besonders geeignet haben sich lineare, aromatische Polyurethanelestomere erwiesen, wie sie beispielsweise aus Butandiolpolyadipat, Neopentylglykol und 4'4-Diphenylmethandiisocyanat hergestellt werden.

Zur Erhöhung der Haftfestigkeit der erfindungsgemäßen Formulierungen auf den Oberflächen kann es auch erforderlich sein, den erfindungsgemäßen Bindemitteln Polyisocyanate oder freie Isocyanatgruppen enthaltende Oligo- oder Polyurethane zuzugeben. Als besonders günstig haben sich hierbei Zusätze erwiesen, die freie aliphatische Isocyanatgruppen enthalten.

Als Beispiele seien genannt:

Organische Polyisocyanate wie sie z.B. gemäß EP-A - 0 160 913 erhalten werden. Dabei handelt es sich um Biuretpolyisocyanate auf Basis von 1,6-Diisocyanatohexan, Isocyanatgruppen aufweisende Polyisocyanate auf Basis von 1-Isocyanato-3,3,5-trimethyl-5-isocyanatomethyl-cyclohexan und Isocyanuratgruppen aufweisende Polyisocyanate auf Basis von Gemischen von 1,6-Diisocyanatohexan und 1-Isocyanato-3,3,5-trimethyl-5-isocyanatomethylcyclohexan. Biuretgruppen aufweisende Polyisocyanate wie sie beispielsweise gemäß DE-A 1 101 394 ( = US 3 124 605), US 3 358 010 oder EP-PS 3505 ( = US - 4 264 519) zugänglich sind. Uretdion-und Isocyanuratgruppen aufweisende organische Polyisocyanate wie sie z.B. nach der Lehre der DE-A 1 954 093 ( = GB 1 244 416) oder nach EP 0 173 252 erhalten werden.

Bei Verwendung von Polyurethanen mit freien aromatischen Isocyanatgruppen oder aus Lagerbeständigkeitsgründen kann es günstig sein, die freien Isocyanatgruppen auf bekannte Weise reversibel zu blockieren. Derartige Verfahren sind aus der Polyurethanchemie bekannt.

Als Blockierungsmittel können beispielsweise eingesetzt werden, Phenole, Caprolactam, $\beta$-Dicarbonyl-verbindungen wie Acetessigester und Malonester, bestimmte Alkohole, Oxime und Triazole.

Nicht blockierte Isocyanatgruppen enthaltende Bindemittel sollten erst kurz vor der Verarbeitung den

2

erfindungsgemäßen Formulierungen zugegeben werden.

Als Aktivatoren kommen in den erfindungsgemäßen Formulierungen organische Verbindungen der 1. oder 8 Nebengruppen des Periodensystems (insbesondere Pd, Pt, Au und Ag) in Betracht, wie sie beispielsweise in den EP-A 34 485, 81 438, 131 195 beschrieben werden. Besonders geeignet sind organische Verbindungen des Palladiums mit Olefinen (Dienen), mit $\alpha$, $\beta$-ungesättigten Carbonylverbindungen, mit Kronenethern und mit Nitrilen. Ganz besonders geeignet sind Butadienpalladiumdichlorid, Bisacetonitrilpalladiumdichlorid, 4-Cyclohexen-1,2-dicarbonsäureanhydridpalladiumdichlorid, Mesityloxidpalladiumchlorid, 3-Hepten-2-on-palladiumchlorid, 5-Methyl-3-hexen-2-on-palladiumchlorid.

Selbstverständlich können auch Gemische dieser Verbindungen eingesetzt werden. Sie können in den Formulierungen gelöst oder dispergiert vorliegen. Eine Lösung kann dabei auch durch Zusatz von Lösungsvermittlern hergestellt werden, z.B. von quaternären Ammoniumsalzen, wie Tetrabutylammoniumbromid. Bei einer Dispergierung der Aktivatoren ist dafür zu sorgen, daß Teilchengrößen unterhalb von 1 μm erreicht werden.

Neben den Aktivatoren, Füllstoffen Bindemitteln und Lösemittel enthalten die Formulierungen gegebenenfalls Tenside, Verlaufsmittel und/oder Farbstoffe.

Als Lösungsmittel in den erfindungsgemäßen Formulierungen kommen in der Druck- bzw. Lackiertechnik bekannte Substanzen in Betracht wie aromatische und aliphatische Kohlenwasserstoffe, beispielsweise Toluol, Xylol, Benzin, Glyzerin; Ketone, beispielsweise Methylethylketon, Cyclohexanon; Ester, beispielsweise Essigsäurebutylester, Phthalsäuredioctylester, Glykolsäurebutylester, Glykolether, beispielsweise Ethylenglykolmonomethylether, Diglyme, Propylenglykolmonomethylether; Ester von Glykolethern, beispielsweise Ethylenglykolacetat, Propylenglykolmonomethyletheracetat; Diacetonalkohol. Selbstverständlich können auch Gemische dieser Lösungsmittel und ihre Verschnitte mit anderen Lösungsmitteln eingesetzt werden. Bevorzugt sind Lösungsmittel mit einer Verdunstungszahl > 25 (Diethylether = 1).

Als Füllstoffe kommen aus der Druck- bzw. Lackierungstechnik bekannte Hilfsstoffe wie Pigmente, disperse Kieselsäuren, Tonmineralien, Ruße und rheologische Additive in Betracht.

Als Beispiele seien genannt:

Aerosile, $TiO_2$, Talkum, Eisenoxide, Kieselgur, Schwerspate, Kaoline, Quarzmehl, Smectite, Farbruße, Graphite, Zinksulfide, Chromgelb, Bronzen, organischen Pigmente und Kreide. Bevorzugt sind Aerosile, Schwerspate und $TiO_2$.

Die Herstellung der erfindungsgemäßen Formulierungen geschieht im allgemeinen durch Vermischen der Bestandteile. Dazu sind neben den einfachen Rühren besonders die in der Lack- und Drucktechnik üblichen Naßverkleinerungsaggregate wie Kneter, Attritore, Walzenstühle, Dissolver, Rotor-Stator-Mühlen, Kugelmühlen sowie Rührwerkmühlen besonders geeignet. Selbstverständlich kann das Einarbeiten der Formulierungsbestandteile auch in getrennten Schritten durchgeführt werden. Beispielsweise kann man den Aktivator zuerst in den Bindern und Lösungsmitteln lösen bzw. dispergieren und dann erst die Füllstoffe einarbeiten. Auch ein vorheriges Anteigen der Füllstoffe in den Lösungsmitteln unter hohen Scherkräften ist eine mögliche Verfahrensvariante.

Durch Aufbringen der erfindungsgemäßen Formulierungen können Oberflächen zum Zweck einer haftfesten chemogalvanischen Metallisierung aktiviert werden. Das Aufbringen erfolgt im allgemeinen durch aus der Lack- bzw. Drucktechnik bekannte Verfahren.

Als Beispiele seien genannt:

Aufsprühen, Aufpinseln, Aufrollen, Offsetdruck, Siebdruck, Tampondruck, Tauchen.

Als Substrate für das erfindungsgemäße Verfahren eignen sich Polyethylen, Polypropylen, Epoxidharze, Polyester, Polycarbonate, Polyamide, Polyimide, Polyhydantoine, ABS-Kunststoffe, Silikone, Polyvinylhalogenide, Polyvinildenfluorid in Form von Platten, Folien, Papieren und Vliesen. Besonders bevorzugt sind Substrate, wie sie in der Leiterplattenfertigung eingesetzt werden, z. B. Phenolharzpapiere, Glasfaserverstärkte Epoxidplatten, Polyester- und Polyimidfolien.

Nach dem Aufbringen der erfindungsgemäßen Formulierungen auf die Oberfläche werden die Lösungsmittel entfernt. Im allgemeinen geschieht dies durch Trocknen.

Das Trocknen kann bei unterschiedlichen Temperaturen, beispielsweise zwischen RT und 200°C und unter Normaldruck oder auch im Vakuum erfolgen. Die Trocknungszeit kann selbstverständlich stark variiert werden.

Die so bekeimten Oberflächen müssen anschließend durch Reduktion aktiviert werden. Dazu können bevorzugt die in der Galvanotechnik üblichen Reduktionsmittel, wie z,B, Formaldehyd, Hypophosphite und Borane verwendet werden.

Eine besonders bevorzugte Ausführungsform bei Verwendung der erfindungsgemaßen Formulierungen besteht darin, daß die Reduktion im Metallisierungsbad gleich mit dem Reduktionsmittel der stromlosen Metallisierung durchgeführt wird. Diese Ausführung ist besonders für aminboranhaltige Nickelbäder oder formalinhaltige Kupferbäder geeignet.

Die mit den erfindungsgemäßen Formulierungen aktivierten oberflächen können in einem weiteren Verfahrensschritt stromlos metallisiert werden. Dafür kommen besonders Bäder mit Nickel-, Cobalt-, Eisen-, Kupfer-, Silber, Gold- und Palladiumsalzen oder deren Gemische in Betracht. Derartige Metallisierungsbäder sind in der Technik der stromlosen Metallisierung bekannt.

Die erfindungsgemäßen Formulierungen eignen sich besonders für eine partielle Aktivierung von Oberflächen, ganz besonders zur Herstellung von gedruckten Schaltungen, Folientastaturen, Schaltmatten und Sensoren nach Druckverfahren insbesonder Siebdruckverfahren und anschließender additiven chemischen Metallisierung.

Beispiel 1:

Aus Butandiolpolyadipat (MG 2 000), Neopentylglycol und 4,4-Diphenylmethan-diisocyanat wird ein nicht reaktives Polyurethanelastomer hergestellt.

```
20 Gew.-Teile einer 30 %igen Lösung dieses Polyurethans in
                      N-Methylpyrrolidon: Ethylenglykolethylether-
                      acetat = 1:1
  4  "      "      Aerosil® (200 m²/g nach BET)
 20  "      "      Ethylenglykolethyletheracetat
  4  "      "      eines handelsüblichen Einbrennurethanharzes

                  auf Basis Isophorondiisocyanat/Malonester

                  blockiert ca. 75 % Lösung in Ethylglykol

                  acetat/Xylol 1:1 NCO-Gehalt blockiert ca.

                  10 %

  1  "      "      5-Methyl-3-hexan-2-on-palladiumchlorid
```

werden im Dissolver sorgfältig vermischt bzw. dispergiert.

Die entstehende Paste wird durch ein Sieb auf eine PESFolie gedruckt und der Druck 1 Stunde bei 150°C getrocknet. Anschließend wird die Oberfläche 5 Minuten in einer 1 %igen alkalischen Aminboranlösung vorreduziert, gespült und dann 1 Stunde in einem formalinhaltigen Kupferbad bei 60°C verkupfert. Man erhält eine zusammenhängende Metallschicht der Dicke 2,8 $\mu$m. Haftfestigkeit gemäß DIN 53 151: Kennwert: GT 3.

Beispiel 2:

```
60 Gew.-Teile einer 30 %igen Polyurethanlösung gemäß
                      Beispiel 1
  1  "      "      Diacetonitrilpalladiumdichlorid
  5  "      "      Aerosil® (380 m²/g nach BET)
 30  "      "      Glykolethyletheracetat
  1  "      "      Siliconöl M 100
```

werden über einen 3-Walzenstuhl sorgfältig vermischt bzw. dispergiert und gemäß Beispiel 1 verdruckt, getrocknet und die Oberflächen verkupfert. Man erhält eine zusammenhängende Metallschicht mit einer Haftfestigkeit gemäß DIN 53 494 von 36 N.

Beispiel 3:

```
100 Gew.-Teile  einer  30 %igen Lösung eines Polyurethans ge-
                        mäß Beispiel 1 in Ethylenglykoletheracetat
  9  "        "         Aerosil® (380 m²/g nach BET)
 50  "        "         Glykolmethyletheracetat
 16  "        "         eines Uretdion- und Isocyanuratgruppen
                        aufweisenden Polyisocyanat auf Basis 1,6-
                        Diisocyanatohexan mit einem NCO-Gehalt
                        von 22,7 %
  1,5 "        "        Tetrahydrophthalsäureanhydridpalladium-
                        dichlorid
```

werden in einem Kneter sorfältig miteinander vermischt.

Anschließend wird die entstehende Paste gemäß Beispiel 1 verdruckt und der Druck verkupfert. Man erhält eine zusammenhängende Metallschicht. Die Haftfestigkeit kann nach DIN 53 494 nicht mehr exakt bestimmt werden, da das Kupfer nicht zerstörungsfrei von der Polyesterfolie abgezogen werden kann.

Beispiel 4 :

```
650 Gew.-Teile  einer  30 %igen Polyurethanlösung eines
                        Polyurethans aus Butandioladipat
                        (MG 2 000), Neopentylglykol und
                        4,4'-Diphenylmethan-diisocyanat  in
                        Ethylenglykolethyletheracetat

330  "        "         Glykolmethyletheracetat
 55  "        "         Aerosil® (380 m²/g nach BET)
 52  "        "         Helioechtblau GO
 13  "        "         Butadienpalladiumchlorid
```

werden sorgfältig über einen 3-Walzenstuhl vermischt bzw. dispergiert und gemäß Beispiel 1 auf eine PESFolie gedruckt. Durch stromlose Verkupferung des Druckes erhält man eine Kupferschicht mit einer Haftfestigkeit gemäß DIN 53 494 von 21 N.

**Patentansprüche**

1. Verfahren zur Verbesserung der Haftfestigkeit von stromlos abgeschiedenen Metallschichten auf Kunststoffoberflächen durch Aufbringung einer Druckpastenformulierung, die als Bestandteile
   a) 0.03-4.00 Gew.% einer organischen Edelmetallverbindung als Aktivator
   b) 10-30 Gew.% eines Polyurethanelastomers als Bindemittel
   c) 5 - 25 Gew.% eines Füllstoffs und
   d) mindestens 40 Gew.% eines halogenfreien Lösungsmittels oder Lösungsmittelgemisches mit einem Flammpunkt >21°C und Siedepunkt >100°C,
   enthält, Entfernen der Lösungsmittel, Reduktion der getrockneten Oberflächen und stromlose Metallisierung.

**2.** Verfahren nach Anspruch 1, dadurch gekennzeichnet, daß man als Aktivatoren organische Verbindungen von Pd, Pt, Ag oder Au verwendet,

**3.** Verfahren nach Anspruch 1, dadurch gekennzeichnet, daß man Polyurethanelastomere, die frei von Isocyanatgruppen sind, verwendet.

**4.** Verfahren nach Anspruch 1, dadurch gekennzeichnet, daß man den Formulierungen kurz vor der Verarbeitung zusätzlich Polyisocyanate oder freie Isocyanatgruppen enthaltende Oligo- oder Polyurethane zusetzt.

**5.** Verfahren nach Anspruch 1, dadurch gekennzeichnet, daß die Formulierungen als Füllstoffe Aerosile, $TiO_2$ oder Schwerspate enthalten.

**6.** Verwendung von Formulierungen gemäß Anspruch 1 als Druckpasten zur Herstellung von gedruckten Schaltungen, Folientastaturen, Schaltmatten und Sensoren.

**Claims**

**1.** Process for improving the adherency of metal coatings deposited without current on plastic surfaces by treating the latter with a printing paste formulation which contains, as components,
   a) 0.03-4.00% by weight of an organic noble metal compound as activator
   b) 10-30% by weight of a polyurethane elastomer as binder
   c) 5-25% by weight of a filler and
   d) at least 40% by weight of a halogen-free solvent or solvent mixture having a flashpoint $>21°C$ and a boiling point $>100°C$,
removing the solvents, reducing the dried surfaces and metallising without current.

**2.** Process according to Claim 1, characterised in that the activators used are organic compounds of Pd, Pt, Ag or Au.

**3.** Process according to Claim 1, characterised in that the polyurethane elastomers used are free of isocyanate groups.

**4.** Process according to Claim 1, characterised in that in addition polyisocyanates, or oligourethanes or polyurethanes containing free isocyanate groups are added to the formulations shortly before processing.

**5.** Process according to Claim 1, characterised in that the formulations contain Aerosils, $TiO_2$ or heavy spars as fillers.

**6.** Use of formulations according to Claim 1 as printing pastes for the production of printed circuits, foil keyboards, pressure-sensitive mats and sensors.

**Revendications**

**1.** Procédé d'amélioration de la force d'adhérence de couches métalliques déposées chimiquement sur des surfaces en matière plastique par application d'une composition de pâte d'impression contenant comme composants
   a) 0,03 à 4,00 % en poids d'un composé organique de métal noble comme activateur
   b) 10 à 30 % en poids d'un élastomère de polyuréthanne comme liant
   c) 5 à 25 % en poids d'une charge et
   d) au moins 40 % en poids d'un solvant ou mélange de solvants exempt d'halogènes ayant un point d'inflammation $> 21°C$ et un point d'ébullition $> 100°C$,
élimination des solvants, réduction des surfaces séchées et métallisation chimique.

**2.** Procédé selon la revendication 1, caractérisé en ce qu'on utilise comme activateurs des composés organiques de Pd, Pt, Ag ou Au.